# EUROPEAN PATENT SPECIFICATION

(11) **EP 2 667 507 B1**
(45) Date of publication and mention of the grant of the patent: **29.10.2014**
(21) Application number: 12360041.3
(22) Date of filing: 21.05.2012
(51) Int. Cl.: H03F 1/32, H03F 1/02

(54) **Amplifier**
Verstärker
Amplificateur

(43) Date of publication of application: 27.11.2013
(73) Proprietor: ALCATEL LUCENT, 92100 Boulogne-Billancourt (FR)
(72) Inventor: Wong, James, Richmond, Surrey TW9 3JX (GB); Woodington, Simon, Cardiff S Glamorgan CF5 2JL (GB)
(74) Representative: Sarup, David Alexander

(56) References cited:
- WO-A1-2008/064492
- WO-A2-2008/078195
- US-A1- 2005 231 279
- US-A1- 2005 258 898
- US-A1- 2010 253 426
- US-A1- 2011 080 216
- US-A1- 2011 234 314
- US-B1- 6 252 912
- HAIYING CAO ET AL: "Digital predistortion for dual-input Doherty amplifiers", POWER AMPLIFIERS FOR WIRELESS AND RADIO APPLICATIONS (PAWR), 2012 IEEE TOPICAL CONFERENCE ON, IEEE, 15 January 2012 (2012-01-15), pages 45-48, XP032153882, DOI: 10.1109/PAWR.2012.6174934 ISBN: 978-1-4577-1119-0
- HAIYING CAO ET AL: "Digital Predistortion for High Efficiency Power Amplifier Architectures Using a Dual-Input Modeling Approach", IEEE TRANSACTIONS ON MICROWAVE THEORY AND TECHNIQUES, IEEE SERVICE CENTER, PISCATAWAY, NJ, US, vol. 60, no. 2, 1 February 2012 (2012-02-01), pages 361-369, XP011398812, ISSN: 0018-9480, DOI: 10.1109/TMTT.2011.2176956
- HAIYING CAO ET AL: "Linearization of Efficiency-Optimized Dynamic Load Modulation Transmitter Architectures", IEEE TRANSACTIONS ON MICROWAVE THEORY AND TECHNIQUES, IEEE SERVICE CENTER, PISCATAWAY, NJ, US, vol. 58, no. 4, 1 April 2010 (2010-04-01), pages 873-881, XP011305979, ISSN: 0018-9480
- BRAITHWAITE R N ET AL: "An Improved Doherty Amplifier Using Cascaded Digital Predistortion and Digital Gate Voltage Enhancement", IEEE TRANSACTIONS ON MICROWAVE THEORY AND TECHNIQUES, IEEE SERVICE CENTER, PISCATAWAY, NJ, US, vol. 57, no. 12, 1 December 2009 (2009-12-01), pages 3118-3126, XP011283858, ISSN: 0018-9480, DOI: 10.1109/TMTT.2009.2033240
- JUNGHWAN MOON ET AL: "Enhanced Hammerstein Behavioral Model for Broadband Wireless Transmitters", IEEE TRANSACTIONS ON MICROWAVE THEORY AND TECHNIQUES, IEEE SERVICE CENTER, PISCATAWAY, NJ, US, vol. 59, no. 4, 1 April 2011 (2011-04-01), pages 924-933, XP011372581, ISSN: 0018-9480, DOI: 10.1109/TMTT.2011.2110659
- GHANNOUCHI F M ET AL: "Behavioral modeling and predistortion", IEEE MICROWAVE MAGAZINE, IEEESERVICE CENTER, PISCATAWAY, NJ, US, vol. 10, no. 7, 1 December 2009 (2009-12-01), pages 52-64, XP011347087, ISSN: 1527-3342, DOI: 10.1109/MMM.2009.934516

## Description

### FIELD OF THE INVENTION

The present invention relates to an amplifier and a method.

### BACKGROUND

Amplifiers are known. In most communications systems, it is required that power amplifiers used to amplify signals for transmissions are able to operate with high efficiency and high linearity simultaneously. However, there is typically a trade-off between efficiency and linearity, with improvements in one generally coming at the expense of the other. Many wireless telecommunications systems, such as a Global System for Mobile communications (GSM)/Enhanced Data rates for GSM Evolution (EDGE), Code Division Multiple Access (CDMA) or Wideband Code Division Multiple Access (WCDMA) require that the power amplifier is able to deliver a wide range of output powers.

Accordingly, the power amplifiers are typically designed to provide the highest power output level with the maximum available efficiency. These amplifiers, which may be provided in base stations, tend to operate less efficiently at lower power levels. Designing a base station power amplifier which has a high efficiency and high linearity, not only at the maximum output power but also at lower output power levels, typically ranging from -6dB and less, without using additional linearization schemes, is challenging. A Doherty power amplifier is one such power amplifier in which a main amplifier is provided in parallel with an auxiliary amplifier. The input signal is split and provided to each of the amplifiers. Both of the amplifiers then amplify the signal, which is then combined to create an output signal. When operating at the maximum power output, both amplifiers are used. However, when the total output power is typically less than 6dB from the maximum output power, the auxiliary amplifier is turned off.

Typically, components of an amplifier introduce non-linearity in the output signal. It is possible to use, for example, digital pre-distortion to ameliorate problems associated with such frequency distortion. Digital pre-distortion is typically applied to the input signal. In amplifier arrangements, such as a Doherty amplifier, where multiple amplifier "stages" are provided in parallel, it may be necessary to apply different digital pre-distortion to the input signal to provide a different pre-distortion signal to each parallel stage in order to compensate for the different non-linearity provided by each stage.

Although the use of pre-distortion can improve the performance and efficiency of amplifiers, unexpected consequences can occur.

"Digital Predistortion for Dual-Input Doherty Amplifiers" by Haiying Cao et al.2012 IEEE Topical conference on 15 January 2012, pages 45 - 48 discloses a digital predistortion technique for a dual-input Doherty power amplifier in which a modified pre-distorted signal is generated using static functions having polynomial fitting errors.

Accordingly, it is desired to provide an improved amplifier.

### SUMMARY

According to a first aspect, there is provided an amplifier comprising: a signal conditioner comprising: an input operable to receive an initial pre-distorted signal that has been generated by applying a pre-distortion function having a number of polynomial terms to an input signal; a signal conditioning network comprising a diode and impedance network operable to receive the initial pre-distorted signal and that is operable to increase the effective number of polynomial terms applied to the input signal and generate a modified pre-distorted signal; and an output operable to provide the modified pre-distorted signal.

The first aspect recognizes that providing an amplifier arrangement having a high degree of linearization typically requires complex pre-processing of the input signal in order to compensate for the lack of linearity within the amplifier. In particular, the first aspect recognizes that it is typically necessary to apply complex pre-distortion functions to a signal to be amplified in order to compensate for and cancel the non-linearities introduced by the amplifier. Typically, this is achieved through the application of a fixed set of mathematical equations which define the pre-distortion to be applied. Such mathematical equations or functions are normally defined and fixed for particular operating conditions and rely on prediction mathematics to redefine these functions when the operating conditions change. Also, to achieve a high degree of linearization requires that the pre-distortion function provides a high number of polynomial terms in order to accurately distort the input signal and thereby accurately compensate for the non-linearity of the amplifier. Supporting a high order pre-distortion function requires significant resources, which also typically occupies a large amount of space.

Accordingly, an amplifier is provided. The amplifier comprises a signal conditioner. The signal conditioner or conditioning network receives an initial pre-distorted signal. The signal conditioner generates a modified pre-distorted signal from the initial pre-distorted signal. The signal conditioning network increases the effective number of polynomial terms applied to the input signal. In this way, the accuracy of the pre-distorted signal may be increased by effectively increasing the number of polynomial terms used to generate that signal. This arrangement simplifies the generation of pre-distorted signal, which reduces the complexity of the pre-distortion function and therefore reduces the resources required to perform that function. This reduction in resources also reduces the amount of space occupied by those resources and so reduces the size of the amplifier.

In one embodiment, the initial pre-distorted signal comprises an initial number of polynomial terms and the modified pre-distorted signal comprises greater than the initial number of polynomial terms. Accordingly, the number of polynomial terms is larger after the generation of the modified pre-distorted signal.

In one embodiment, the amplifier comprises an initial pre-distorter operable to generate the initial pre-distorted signal using an initial pre-distortion function having the initial number of polynomial terms. Accordingly, an initial pre-distorter may be provided. However, the number of polynomial terms required by the function executed by the initial pre-distorter can be considerably less than would otherwise be necessary in the absence of the signal conditioner.

In one embodiment, the signal conditioning network is operable to generate the modified pre-distorted signal using a modified pre-distortion function providing greater than the initial number of polynomial terms. Accordingly, the signal conditioning network effectively increases the number of polynomial terms of the function used to generate the modified pre-distorted signal.

In one embodiment, the initial pre-distorter comprises a digital initial pre-distorter operable to generate the initial pre-distorted signal using the initial pre-distortion function having the initial number of polynomial terms.

In one embodiment, the initial pre-distorted signal comprises 'n' polynomial terms and the signal conditioning network is operable to generate the modified pre-distorted signal comprising '2n' polynomial terms. Accordingly, the signal conditioning network may double the number of polynomial terms of the function used to generate the modified pre-distorted signal. This enables the function performed by the initial pre-distorter to have half the required number of polynomial terms as would otherwise be required to achieve a similar modified pre-distorted signal.

In one embodiment, the initial pre-distorted signal is generated using the initial pre-distortion function comprising 'n' polynomial terms and the signal conditioning network generates the modified pre-distorted signal using the modified pre-distortion function comprising '2n' polynomial terms.

In one embodiment, the signal conditioning network is operable generate the modified pre-distorted signal by increasing a peak amplitude of the initial pre-distorted signal at an operating frequency. Accordingly, the amplitude of the pre-distorted signal may be increased at the operating frequency in order to improve the efficiency of the amplifier.

In one embodiment, the signal conditioning network is operable generate the modified pre-distorted signal by decreasing a peak amplitude of the initial pre-distorted signal at an operating frequency. Accordingly, the signal conditioning network may reduce the amplitude of the initial pre-distorted signal at the operating frequency in order to improve the efficiency of the amplifier.

The signal conditioner comprises a diode and impedance network operable to receive the initial pre-distorted signal and to generate the modified pre-distorted signal. The presence of a diode and its associated square law function effectively doubles the number of polynomial terms used to generate the modified pre-distorted signal. It will be appreciated that this provides a convenient mechanism to generate the modified pre-distorted signal using a simplified initial pre-distorter.

In one embodiment, the diode and impedance network comprises a diode coupled in series between the input and the output. Providing the diode in series enables the amplitude of the pre-distorted signal to be increased.

In one embodiment, the diode and impedance network comprises a diode coupled in shunt between the input and the output. Providing the diode in shunt enables the amplitude of the pre-distorted signal to be decreased.

In one embodiment, the amplifier comprises a plurality of the signal conditioners, each operable to receive the initial pre-distorted signal at a respective input and to provide the modified pre-distorted signal a respective output. Accordingly, more than one signal conditioner may be provided in order to support a multi-stage amplifier.

In one embodiment, the amplifier is a Doherty amplifier, one output is coupled with a main branch of the Doherty amplifier and another output is coupled with an auxiliary branch of the Doherty amplifier. Accordingly, this approach is particular effective when used in a Doherty architecture.

In one embodiment, the signal conditioner coupled with the main branch limits an amplitude of the initial pre-distorted signal to generate the modified pre-distorted signal.

In one embodiment, the signal conditioner coupled with the main branch limits by decreasing a peak to average voltage of the initial pre-distorted signal to generate the modified pre-distorted signal.

In one embodiment, the signal conditioner coupled with the auxiliary branch expands an amplitude of the initial pre-distorted signal to generate the modified pre-distorted signal.

In one embodiment, the signal conditioner coupled with the auxiliary branch expands by increasing a peak to average voltage of the initial pre-distorted signal to generate the modified pre-distorted signal.

According to a second aspect, there is provided a method comprising the steps of: receiving an initial pre-distorted signal that has been generated by applying a pre-distortion function having a number of polynomial terms to an input signal; generating a modified pre-distorted signal from the initial pre-distorted signal by passing said signal through a signal conditioning network comprising a diode and impedance network such that the effective number of polynomial terms applied to the input signal is increased; and outputting the modified pre-distorted signal.

In one embodiment, the initial pre-distorted signal comprises an initial number of polynomial terms and the modified pre-distorted signal comprises greater than the initial number of polynomial terms.

In one embodiment, the method comprises generating the initial pre-distorted signal using an initial pre-distortion function having the initial number of polynomial terms.

In one embodiment, the step of generating the modified pre-distorted signal comprises generating the modified pre-distorted signal using a modified pre-distortion function providing greater than the initial number of polynomial terms.

In one embodiment, the initial pre-distorted signal comprises 'n' polynomial terms and the step of generating the modified pre-distorted signal comprises generating the modified pre-distorted signal comprising '2n' polynomial terms.

In one embodiment, the step of generating the initial pre-distortion signal comprises generating the initial pre-distortion signal using the initial pre-distortion function comprising 'n' polynomial terms and the step of generating the modified pre-distorted signal comprises generating the modified pre-distorted signal using the modified pre-distortion function comprising '2n' polynomial terms.

In one embodiment, the step of generating the modified pre-distorted signal comprises increasing a peak amplitude of the initial pre-distorted signal at an operating frequency.

In one embodiment, the step of generating the modified pre-distorted signal comprises decreasing a peak amplitude of the initial pre-distorted signal at an operating frequency.

In one embodiment, the step of generating the modified pre-distorted signal comprises using a diode and impedance network operable receive the initial pre-distorted signal and to generate the modified pre-distorted signal.

In one embodiment, the step of generating the modified pre-distorted signal comprises coupling a diode in series between the input and the output.

In one embodiment, the step of generating the modified pre-distorted signal comprises coupling a diode coupled in shunt between the input and the output.

In one embodiment, the method comprises receiving the initial pre-distorted signal and providing a plurality of the modified pre-distorted signals.

In one embodiment, the method comprises the step of limiting an amplitude of the initial pre-distorted signal to generate the modified pre-distorted signal.

In one embodiment, the step of limiting comprises decreasing a peak to average voltage of the initial pre-distorted signal to generate the modified pre-distorted signal.

In one embodiment, the method comprises the step of expanding an amplitude of the initial pre-distorted signal to generate the modified pre-distorted signal.

In one embodiment, the step of expanding comprises increasing a peak to average voltage of the initial pre-distorted signal to generate the modified pre-distorted signal.

According to a third aspect, there is provided a Doherty amplifier comprising: a main signal conditioner coupled with a main amplifier stage comprising: a main input operable to receive an initial pre-distorted signal; a main signal conditioning network to receive the initial pre-distorted signal and to generate a main modified pre-distorted signal having a decreased peak amplitude of the initial pre-distorted signal at an operating frequency; and an auxiliary signal conditioner coupled with an auxiliary amplifier stage comprising: an auxiliary input operable to receive the initial pre-distorted signal; an auxiliary signal conditioning network to receive the initial pre-distorted signal and to generate an auxiliary modified pre-distorted signal having a decreased peak amplitude of the initial pre-distorted signal at the operating frequency.

In embodiments, features of the first aspect may be combined with features of the third aspect.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates an amplifier according to one embodiment;
Figure 2 illustrates an attenuator and signal delay network according to one embodiment;
Figure 3 illustrates two embodiments of a signal conditioner;
Figure 4 illustrates the transfer function of the two embodiments of the signal conditioner shown in Figure 3;
Figure 5 illustrates the modified pre-distorted signals after passing through the two embodiments of the signal conditioner shown in Figure 3;
Figure 6 illustrates the performance of an example digital Doherty amplifier with and without linearization; and
Figure 7 illustrates the performance of the amplifier of Figure 1 with and without linearization.

### DESCRIPTION OF THE EMBODIMENTS

### Overview

Before discussing the embodiments in any more detail, first and overview will be provided. Embodiments enable a complex, pre-distorted signal to be generated for subsequent amplification by one or more amplification stages of an amplifier. As mentioned above, such pre-distortion is applied to an input signal in order to compensate for the non-linear performance of that particular amplifier. In other words, the pre-distortion enables the amplifier to produce an output signal which is closer to an ideal signal which would be produced if the amplifier had a more linear performance.

In order to compensate for the non-linear performance of the amplifier stage or stages, a complex, pre-distorted signal needs to be generated. The pre-distortion function which generates the pre-distorted signal would typically characterize the non-linearity of the amplifier stages using a polynomial function having terms up to a plurality of orders of polynomial terms. For example, it is not uncommon to generate a pre-distorted signal using a polynomial function which characterized the non-linear performance of the amplifier stages up to around a 10th order polynomial term.

As also mentioned above, the generation of a pre-distorted signal using a function having such a high number of polynomial terms requires significant processing resources. Accordingly, embodiments provided technique where an equivalent pre-distorted signal is generated in a less complex manner, using considerably fewer resources.

In particular, a first signal conditioner or pre-distorter is provided which applies a pre-distortion function having a first number of polynomial terms to the input signal to generate a first or initial pre-distorted signal. This initial pre-distorted signal is then passed to a second signal conditioner or pre-distorter which operates to increase the effective number of polynomial terms of the pre-distortion function applied to the input signal.

For example, the initial pre-distorter may apply a first function to the input signal which has five polynomial terms and its output is provided to the second pre-distorter. The second pre-distorter then applies a second function which effectively doubles the number of polynomial terms applied to the input signal and provides this as a modified pre-distorted signal. Hence, the modified pre-distorted signal has been generated by a pre-distortion function having effectively 10 polynomial terms. However, the initial pre-distorter only needed to apply a function having five polynomial terms, rather than 10 polynomial terms, which significantly reduces the processing required of this, typically digital, pre-distorter. Also, the second pre-distorter can be implemented as a simple diode and impedance network, which provides for a simple analogue implementation to double the effective number of polynomial terms in the pre-distortion function. It will be appreciated that this requires significantly fewer resources than would be required to generate an equivalent pre-distorted signal using a single pre-distortion function with 10 polynomial terms.

Alternatively or additionally, the second pre-distorted or can be utilized to vary the peak-to-average levels of the input signal in order to enhance the efficiency of the amplifier stages. In a multiple stage amplifier having separate parallel paths, this enables separate second pre-distorters to be provided on each path to adjust the signal levels in each of those paths having regard to the adjustments required for those individual paths associated with the different parallel stages. With this configuration, it is possible for a single first pre-distorter to be provided which generates a single initial pre-distortion signal for all of the paths, rather than having the first pre-distorter producing different first pre-distortion signals for each path. This helps to simplify the first pre-distorter.

### Example Doherty Amplifier

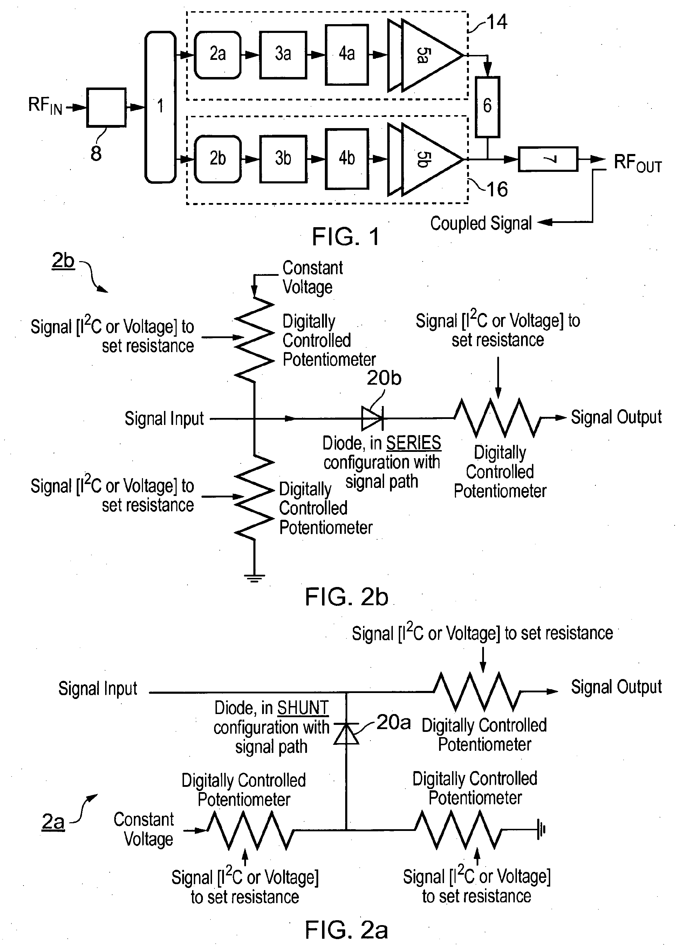

Figure 1 illustrates an amplifier, generally 10, according to one embodiment. This embodiment shows a Doherty amplifier. However, it will be appreciated that the embodiments described may be utilized in many other amplifier arrangements, including Doherty amplifiers having a different number of parallel amplifier stages.

An input signal, RFin is provided to a first pre-distorter 8. The first pre-distorter 8 is a digital pre-distorter which applies a polynomial function to generate a first pre-distorted signal to be output over the path 12. The function applied by the first pre-distorter 8 has, in this example, five polynomial terms and so generates an initial pre-distorted signal having five polynomial terms.

The initial pre-distorted signal is provided to a splitter 1. The splitter 1 splits the signal into the two paths of two parallel stages of the Doherty amplifier 10. One path leads to the main stage 14, whilst the other path leads to the auxiliary stage 16. The splitter 1 may provide either an equal split of the initial pre-distorted signal (using, for example, a 3dB Wilkinson power splitter) or may provide an asymmetric split (using, for example, a directional coupler). The splitter 1 can either provide identical phase signals over the two paths or provide a differential phase between the signals provided over the two paths of either, for example, 90° or 180° through the use of hybrid directional couplers.

As will be explained in more detail below, the initial pre-distorted signal is fed into a signal conditioner 2a in the main stage and a signal conditioner 2b in the auxiliary stage. These two signal conditioners function to effectively increase the number of polynomial terms used to generate their associated modified pre-distorted signal. Additionally, alternatively, the signal conditioners 2a, 2b function to modify the peak to average voltage of their associated modified pre-distorted signal.

Thereafter, the modified pre-distorted signal pass to a respective attenuator 3a, 3a which are identical and contain signal attenuation functions in series with signal delay properties, as illustrated in Figure 2. In particular, a variable attenuator is realized using a resistive network made up of digitally controlled potentiometers. Furthermore, a variable delay is realized by a varactor-transmission line network which uses arrays of varactor diodes to control the effective length of a transmission line to introduce the required amount of delay.

The outputs from the attenuators 3a, 3b are provided to impedance matching circuits 4a, 4b respectively. These matching circuits 4a, 4b provide impedance matching for amplifiers 5a, 5b respectively.

The amplifiers 5a, 5b may be identical or may differ.

The signal provided by the amplifier 5a is provided to an impedance transformer 6 which presents a fixed 90° delay at a particular frequency point. This restores the phase of the signal output by the main stage 14 to that output by the auxiliary stage 16.

The two signals are then combined and input to a combining network and impedance transformer 7. Typically, a Klopfenstein taper may be utilized to provide broadband performance. The impedance transformer 7 then provides the resultant output signal RFₒᵤₜ.

### Signal Conditioners

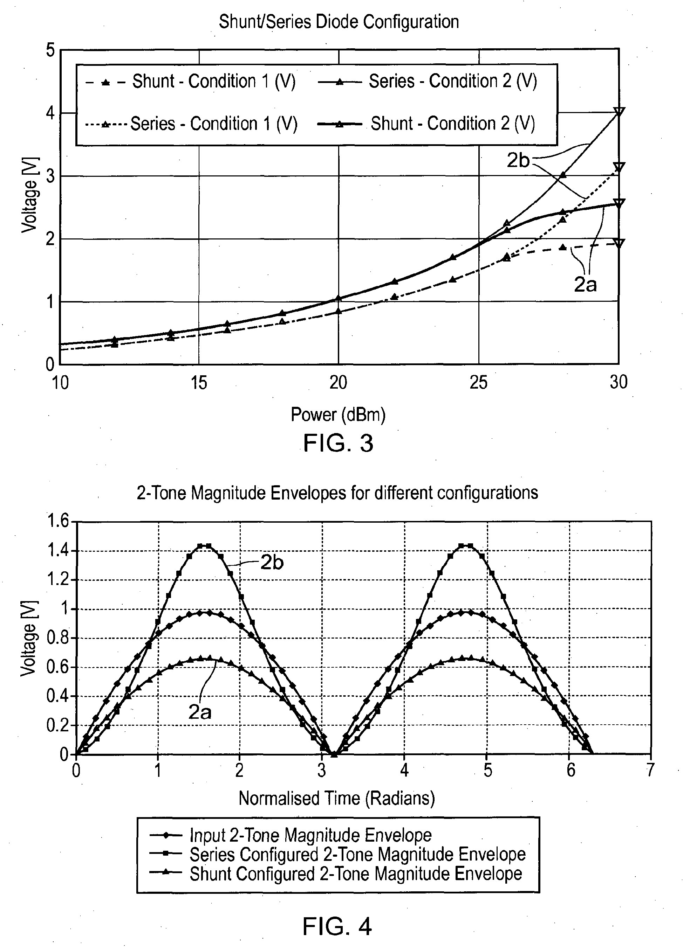

Figure 3 illustrates the configuration of the signal conditioners 2a, 2b in more detail. Both the signal conditioner 2a and the signal conditioner 2b utilize a diode 20a; 20b and impedance network. The diode 20a; 20b exhibits a square-law function which provides a modified pre-distorted signal which is generated with effectively double the number of polynomial terms compared to that of its input signal. That is to say that the combined effect of the first pre-distorter 8 and the signal conditioners 2a, 2b is to generate a pre-distorted signal using an effective pre-distortion function which has double the number of polynomial terms provided by the first pre-distorter 8 alone. In this example, this combined effect generates a modified pre-distorted signal which is similar to that which would have been generated if the first pre-distorter 8 used a 10th order polynomial function. However, only using a fifth order polynomial function in the first pre-distorter 8 significantly simplifies the processing and resources required from this pre-distorter.

In this example arrangement of a Doherty amplifier 10, in order to improve the efficiency of the main stage 14, it may be necessary to reduce the peak-to-average level of the signal within the main amplifier stage. Accordingly, the diode 20a is provided in a shunt arrangement with respect to the signal path, as illustrated in Figure 3. This arrangement provides a signal-limiting transfer function which helps to reduce the peak amplitude of the pre-distorted signal passing through this amplifier stage.

Conversely, it may be necessary in the auxiliary stage 16 to increase the peak-to-average level of the signal within the auxiliary stage to increase the efficiency of that stage. Accordingly, the signal conditioner 2b will contain a series diode 20b, with respect to the signal path, as illustrated in Figure 3. This arrangement provides for a signal-expanding transfer function, which increases the peak amplitude of the pre-distorted signal passing through this amplifier stage.

Figure 4 shows the transfer function of the shunt and series arrangements at different voltages.

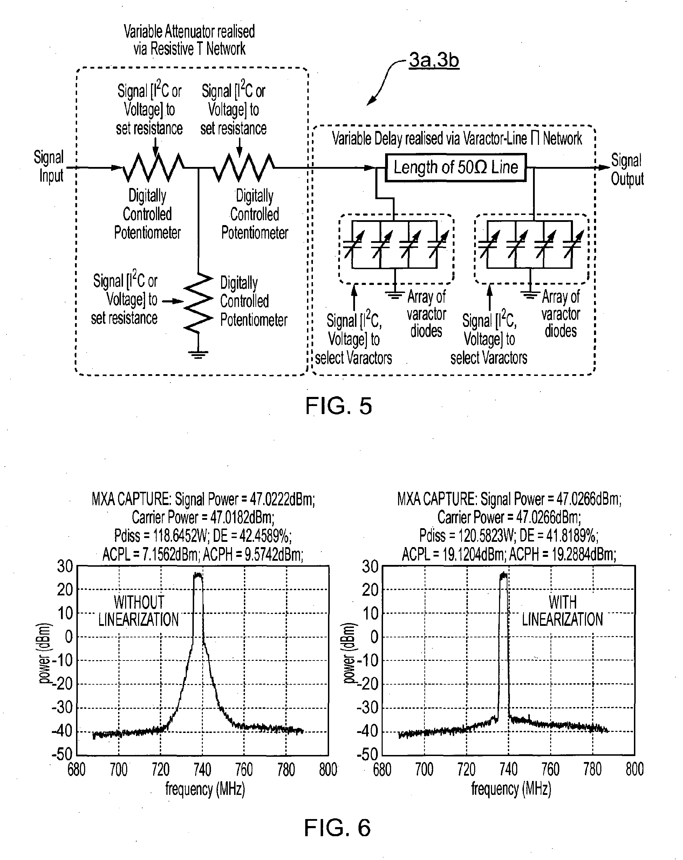

Figure 5 provides an illustration of the modified pre-distorted signals after passing through the signal conditioners 2a; 2b.

Accordingly, it can be seen that the signal conditioners provide for conditioning (either expansion or limitation) of signal peaks between the two individual paths of the digital Doherty amplifier using a simple hardware realisation.

Figure 6 illustrates the performance of an example digital Doherty amplifier with and without linearization. The performance shown with linearization is based on an 11 th order pre-distortion polynomial function being applied to the signal being amplified by the main and auxiliary amplifying stages.

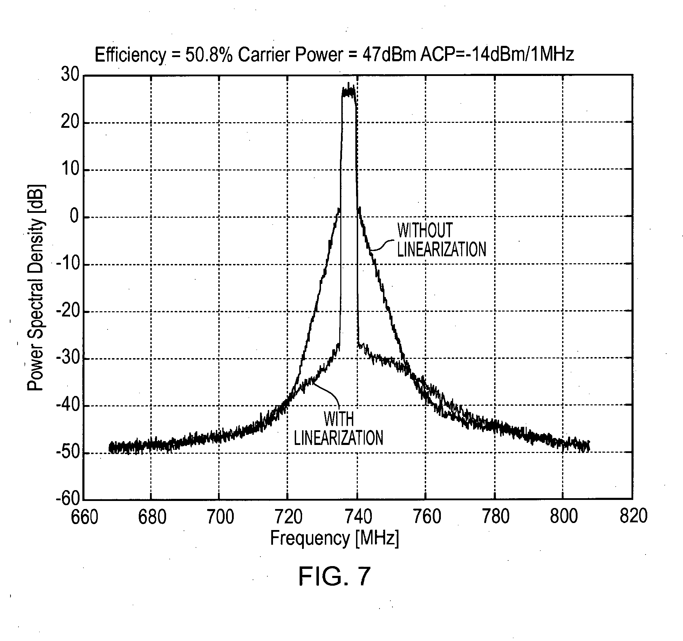

Figure 7 shows the performance of the Doherty amplifier 10 with and without linearization being performed by the initial pre-distorter 1 and the signal conditioners 2a, 2b. As can be seen, the performance of the Doherty amplifier 10 with linearization is significantly improved, and achieves a performance similar to that of the 1 1 th order polynomial function performed by the digital Doherty amplifier.

However, the performance of the Doherty amplifier 10 can be achieved without needing the complexity or resources required by the digital Doherty amplifier to apply such a higher order function to generate the pre-distorted signal. Instead, a close approximation can be achieved simply using an initial pre-distorter using a function having a lower number of polynomial terms and then using the signal conditioners to 2a, 2b to produce a modified pre-distorted signal which is equivalent to that which would have been produced by a polynomial function having double the number of terms.

Table 1 below compares the performance of a Doherty amplifier without linearization, a digital Doherty amplifier with an 11 th order polynomial function and the Doherty amplifier 10 shown in Figure 1.

**Table 1**

| | No Linearization Approach | Full Digital Doherty | Figure 1 embodiment |
|---|---|---|---|
| Carrier Power [dBm] | 47 | 47 | 47 |
| Efficiency [%] | 42 | 51.2 | 50.8 |
| Spectral Emissions [dBm/1MHz] | -19 | -14 | -14 |

As can be seen, the performance of the Doherty amplifier 10 shown in Figure 1 is significantly greater than the arrangement with no linearization, and is very close to the digital Doherty amplifier arrangement which uses an 11th order polynomial pre-distortion function.

An additional benefit of the Doherty amplifier 10 shown in Figure 1 is that the diodes are semiconductor-based and, hence, will present a thermal behaviour which is consistent with the active power transistor devices within the amplifiers 5a, 5b.

Accordingly, embodiments provide an arrangement using a single transmit chain without impacting on the signal linearization integrity of an ideal dual-chained digital Doherty amplifier. This approach, although implemented in the hardware domain, not only provides a reduction of one transmit chain but also reduces the component layout footprint due to the reduction of one of the transmission chains. In addition, this approach provides for performance improvements.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An amplifier comprising:
a signal conditioner (2a, 2b) comprising:
an input operable to receive an initial pre-distorted signal that has been generated by applying a pre-distortion function having a number of polynomial terms to an input signal;
a signal conditioning network comprising a diode (20a, 20b) and impedance network operable to receive said initial pre-distorted signal and that is operable to increase the effective number of polynomial terms applied to the input signal and generate a modified pre-distorted signal ; and
an output operable to provide said modified pre-distorted signal.

2. The amplifier of claim 1, comprising an initial pre-distorter (8) operable to generate said initial pre-distorted signal by applying said pre-distortion function having a number of polynomial terms to an input signal.

3. The amplifier of any preceding claim, wherein said pre-distortion function comprises 'n' polynomial terms and said signal conditioning network is operable to generate said modified pre-distorted signal by effectively doubling to '2n' the number of polynomial terms applied to the input signal.

4. The amplifier of any preceding claim, wherein said signal conditioning network is operable to generate said modified pre-distorted signal by one of increasing and decreasing a peak amplitude of said initial pre-distorted signal at an operating frequency.

5. The amplifier of any preceding claim, wherein said diode and impedance network comprises a diode coupled in series between said input and said output.

6. The amplifier of any preceding claim, wherein said diode and impedance network comprises a diode coupled in shunt between said input and said output.

7. The amplifier of any preceding claim, comprising a plurality of said signal conditioners (2a, 2b), each operable to receive said initial pre-distorted signal at a respective input and to provide said modified pre-distorted signal a respective output.

8. The amplifier of any preceding claim, wherein said amplifier is a Doherty amplifier, one output is coupled with a main branch (14) of said Doherty amplifier and another output is coupled with an auxiliary branch (16) of said Doherty amplifier.

9. The amplifier of claim 8; wherein said signal conditioner coupled with said main branch (14) limits an amplitude of said initial pre-distorted signal to generate said modified pre-distorted signal.

10. The amplifier of claim 9, wherein said signal conditioner coupled with said main branch (14) limits by decreasing a peak to average voltage of said initial pre-distorted signal to generate said modified pre-distorted signal.

11. The amplifier of any of claims 8 to 10, wherein said signal conditioner coupled with said auxiliary branch (16) expands an amplitude of said initial pre-distorted signal to generate said modified pre-distorted signal.

12. The amplifier of claim 11, wherein said signal conditioner coupled with said auxiliary branch (16) expands by increasing a peak to average voltage of said initial pre-distorted signal to generate said modified pre-distorted signal.

13. An amplification method comprising:
receiving an initial pre-distorted signal that has been generated by applying a pre-distortion function having a number of polynomial terms to an input signal;
generating a modified pre-distorted signal from said initial pre-distorted signal, by passing said signal through a signal conditioning network comprising a diode and impedance network such that the effective number of polynomial terms applied to the input signal is increased; and
outputting said modified pre-distorted signal.

## Patentansprüche

1. Verstärker, umfassend:
Einen Signalaufbereiter (2a, 2b), umfassend:
Einen Eingang, betreibbar für den Empfang eines ursprünglichen vorverzerrte Signals, welches durch die Anwendung einer Vorverzerrungsfunktion mit einer Anzahl von Polynomtermen auf ein Eingangssignal erzeugt wurde;
ein Signalaufbereitungsnetzwerk, umfassend ein Dioden- (20a, 20b) und impedanznetzwerk, betreibbar für den Empfang des besagten ursprünglichen vorverzerrten Signals, und betreibbar, um die effektive Anzahl von Polynomtermen, welche auf das Eingangssignal angewendet werden, zu erhöhen und ein modifiziertes vorverzerrtes Signal zu erzeugen; und
einen Ausgang, betreibbar für die Bereitstellung des besagten modifizierten vorverzerrten Signals.

2. Verstärker nach Anspruch 1, umfassend einen ursprünglichen Vorverzerrer (8), betreibbar für die Erzeugung des besagten ursprünglichen vorverzerrten Signals durch Anwenden der besagten Vorverzerrungsfunktion mit einer Anzahl von Polynomtermen auf ein Eingangssignal).

3. Verstärker nach einem beliebigen der vorstehenden Ansprüche, wobei die besagte Vorverzerrungsfunktion 'n' Polynomterme umfasst, und wobei das besagte Signalaufbereitungsnetzwerk betreibbar ist, um das besagte modifizierte vorverzerrte Signal durch effektives Verdoppeln der Anzahl der auf das Eingangssignal angewendeten Polynomterme auf '2n' zu erzeugen.

4. Verstärker nach einem beliebigen der vorstehenden Ansprüche, wobei das besagte Signalaufbereitungsnetzwerk betreibbar ist, um das besagte modifizierte vorverzerrte Signal entweder durch Erhöhen oder durch Senken einer Spitzenamplitude des besagten ursprünglichen vorverzenten Signals bei einer Betriebsfrequenz zu erzeugen.

5. Verstärker nach einem beliebigen der vorstehenden Ansprüche, wobei das besagte Dioden- und Impedanznetzwerk eine zwischen dem besagten Eingang und dem besagten Ausgang in Reihe gekoppelte Diode umfasst.

6. Verstärker nach einem beliebigen der vorstehenden Ansprüche, wobei das besagte Dioden- und Impedanznetzwerk eine zwischen dem besagten Eingang und dem besagten Ausgang in Nebenschluss gekoppelte Diode umfasst.

7. Verstärker nach einem beliebigen der vorstehenden Ansprüche, umfassend eine Vielzahl der besagten Signalaufbereiter (2a, 2b), welche jeweils betreibbar sind, um das besagte ursprüngliche vorverzerrte Signal an einem jeweiligen Eingang zu empfangen und das besagte modifizierte vorverzerrte Signal an einem jeweiligen Ausgang bereitzustellen,

8. Verstärker nach einem beliebigen der vorstehenden Ansprüche, wobei der besagte Verstärker ein Doherty-Verstärker ist, wobei ein Ausgang mit einem Hauptzweig (14) des besagten Doherty-Verstärkers gekoppelt ist und ein anderer Ausgang mit einem Nebenzweig (16) des besagten Doherty-Verstärkers gekoppelt ist.

9. Verstärker nach Anspruch 8, wobei der besagte mit dem besagten Hauptzweig (14) gekoppelte Signalaufbereiter eine Amplitude des besagten ursprünglichen vorverzerrten Signals begrenzt, um das besagte modifizierte vorverzerrte Signal zu erzeugen.

10. Verstärker nach Anspruch 9, wobei die Begrenzung durch den besagten mit dem besagten Hauptzweig (14) gekoppelten Signalaufbereiter durch Senken des Verhältnisses von Spitzen- zu Mittelspannung des besagten ursprünglichen vorverzerrten Signals erfolgt, um das besagte modifizierte vorverzerrte Signal zu erzeugen.

11. Verstärker nach einem beliebigen der Ansprüche 8 bis 10, wobei der besagte mit dem besagten Nebenzweig (16) gekoppelte Signalaufbereiter eine Amplitude des besagten ursprünglichen vorverzerrten Signals erweitert, um das besagte modifizierte vorverzerrte Signal zu erzeugen.

12. Verstärker nach Anspruch 11, wobei die Erweiterung durch den besagten mit dem besagten Nebenzweig (16) gekoppelten Signalaufbereiter durch Erhöhen des Verhältnisses von Spitzen- zu Mittelspannung des besagten ursprünglichen vorverzerrten Signals erfolgt, um das besagte modifizierte vorverzerrte Signal zu erzeugen.

13. Verstärkungsverfahren, umfassend:
Empfangen eines ursprünglichen vorverzerrten Signals, welches durch Anwenden einer Vorverzerrungsfunktion mit einer Anzahl von Polynomtermen auf ein Eingangssignal erzeugt wurde;
Erzeugen eines modifizierten vorverzerrten Signals aus dem besagten ursprünglichen vorverzerrten Signal durch Leiten des besagten Signals durch ein Signalaufbereitungsnetzwerk, welches ein Dioden- und Impedanznetzwerk umfasst, so dass die effektive Anzahl von Polynomtermen, welche auf das Eingangssignal angewendet werden, erhöht wird; und
Ausgeben des besagten modifizierten vorverzerrten Signals.

## Revendications

1. Amplificateur comprenant:
un conditionneur de signal (2a, 2b) comprenant :
une entrée permettant de recevoir un signal prédistordu initial qui a été généré en appliquant une fonction de prédistorsion, présentant un certain nombre de termes polynomiaux, à un signal d'entrée ;
un réseau de conditionnement de signaux comprenant un réseau de diode (20a, 20b) et d'impédance permettant de recevoir ledit signal prédistordu initial et qui permet d'augmenter le nombre effectif de termes polynomiaux appliqués au signal d'entrée et de générer un signal prédistordu modifié ; et
une sortie permettant de fournir ledit signal prédistordu modifié.

2. Amplificateur selon la revendication 1, comprenant une unité de prédistorsion initiale (8) permettant de générer ledit signal prédistordu initial en appliquant ladite fonction de prédistorsion, présentant un certain nombre de termes polynomiaux, à un signal d'entrée.

3. Amplificateur selon l'une quelconque des revendications précédentes, dans lequel ladite fonction de prédistorsion comprend 'n' termes polynomiaux et ledit réseau de conditionnement de signaux permet de générer ledit signal prédistordu modifié en doublant de manière efficace par '2n' le nombre de termes polynomiaux appliqués au signal d'entrée.

4. Amplificateur selon l'une quelconque des revendications précédentes, dans lequel ledit réseau de conditionnement de signaux permet de générer ledit signal prédistordu modifié par une augmentation ou une diminution d'une amplitude de crête dudit signal prédistordu initial à une fréquence de fonctionnement.

5. Amplificateur selon l'une quelconque des revendications précédentes, dans lequel ledit réseau de diode et d'impédance comprend une diode couplée en série entre ladite entrée et ladite sortie.

6. Amplificateur selon l'une quelconque des revendications précédentes, dans lequel ledit réseau de diode et d'impédance comprend une diode couplée en parallèle entre ladite entrée et ladite sortie.

7. Amplificateur selon l'une quelconque des revendications précédentes, comprenant une pluralité desdits conditionneurs de signal (2a, 2b), chacun permettant de recevoir ledit signal prédistordu initial à une entrée respective et de fournir audit signal prédistordu modifié une sortie respective.

8. Amplificateur selon l'une quelconque des revendications précédentes, dans lequel ledit amplificateur est un amplificateur de Doherty, une sortie est couplée à une branche principale (14) dudit amplificateur de Doherty et une autre sortie est couplée à une branche auxiliaire (16) dudit amplificateur de Doherty.

9. Amplificateur selon la revendication 8, dans lequel ledit conditionneur de signal couplé à ladite branche principale (14) limite une amplitude dudit signal prédistordu initial pour générer ledit signal prédistordu modifié.

10. Amplificateur selon la revendication 9, dans lequel ledit conditionneur de signal couplé à ladite branche principale (14) limite par diminution une tension crête à moyenne dudit signal prédistordu initial pour générer ledit signal prédistordu modifié.

11. Amplificateur selon l'une quelconque des revendications 8 à 10, dans lequel ledit conditionneur de signal couplé à ladite branche auxiliaire (16) étend une amplitude dudit signal prédistordu initial pour générer ledit signal prédistordu modifié.

12. Amplificateur selon la revendication 11, dans lequel ledit conditionneur de signal couplé à ladite branche auxiliaire (16) étend par augmentation une tension crête à moyenne dudit signal prédistordu initial pour générer ledit signal prédistordu modifié.

13. Procédé d'amplification comprenant les étapes suivantes :
recevoir un signal prédistordu initial qui a été généré en appliquant une fonction de prédistorsion, présentant un certain nombre de termes polynomiaux, à un signal d'entrée ;
générer un signal prédistordu modifié à partir dudit signal prédistordu initial, en faisant passer ledit signal à travers un réseau de conditionnement de signaux comprenant un réseau de diode et d'impédance de sorte que le nombre effectif de termes polynomiaux appliqués au signal d'entrée soit augmenté ; et
délivrer en sortie ledit signal prédistordu modifié.
